(19)

Europäisches Patentamt

European Patent Office

Office européen des brevets

(11) **EP 2 432 126 B1**

(12) **EUROPÄISCHE PATENTSCHRIFT**

(45) Veröffentlichungstag und Bekanntmachung des Hinweises auf die Patenterteilung:
**20.05.2020   Patentblatt 2020/21**

(21) Anmeldenummer: **11181886.0**

(22) Anmeldetag: **19.09.2011**

(51) Int Cl.:
*H03K 17/96* *(2006.01)*

(54) **Verkleidungselementanordnung und Verfahren zur Herstellung einer berührungsempfindlichen Verkleidung einer Fläche**

Cladding element assembly and method for producing a touch-sensitive cladding of a surface

Agencement d'éléments de revêtement et procédé de fabrication d'un revêtement sensible au contact d'une surface

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.09.2010   DE 102010040993**

(43) Veröffentlichungstag der Anmeldung:
**21.03.2012   Patentblatt 2012/12**

(73) Patentinhaber: **Hochschule für angewandte Wissenschaften**
**Fachhochschule Coburg**
**96450 Coburg (DE)**

(72) Erfinder:
- **Lindner, Gerhard, Prof. Dr. rer. nat.**
  **96450 Coburg (DE)**
- **Meisenbach, Lars**
  **96450 Coburg (DE)**
- **Diller, Wolfgang**
  **96450 Coburg (DE)**

(74) Vertreter: **Maikowski & Ninnemann**
**Patentanwälte Partnerschaft mbB**
**Postfach 15 09 20**
**10671 Berlin (DE)**

(56) Entgegenhaltungen:
**FR-A1- 2 927 574     US-B1- 6 741 237**

EP 2 432 126 B1

**Beschreibung**

Die Erfindung betrifft eine Verkleidungselementanordnung gemäß Anspruch 1 sowie ein Verfahren zum Herstellen einer berührungsempfindlichen Verkleidung einer Fläche gemäß Anspruch 10. Insbesondere betrifft die Erfindung eine Vorrichtung zur Detektion einer Flüssigkeitsbedeckung und/oder eines Kontaktes mit menschlichen Körperteilen mittels einer berührungsempfindlichen Fliese.

Aus dem Stand der Technik sind Verkleidungselemente zum Verkleiden von Flächen, z.B. von Böden oder Wänden, bekannt, beispielsweise in Form von Fliesen.

Die US 6 741 237 B1 offenbart einen Touchscreen mit einem Substrat, in dem mit einem Sender akustische Wellen angeregt werden. Die akustischen Wellen werden mit Hilfe zweier Empfänger detektiert, wobei mittels Laufzeitmessungen der Ort einer Berührung des Substrats bestimmt wird.

Des Weiteren offenbart die FR 2 927 574 A1 eine Vorrichtung zur Detektion von akustischen Wellen in einem Substrat, die bei Berührung des Substrats entstehen.

Das der Erfindung zugrunde liegende Problem besteht darin, eine möglichst vielseitig verwendbare Verkleidung bereitzustellen. Des Weiteren liegt der Erfindung das Problem zugrunde, ein Verfahren zum Herstellen einer entsprechenden Verkleidung zu schaffen.

Dieses Problem wird durch die Verkleidungselement-Anordnung mit den Merkmalen des Anspruchs 1 sowie durch das Verfahren mit den Merkmalen des Anspruchs 10 gelöst.

Weiterbildungen der Erfindung sind in den abhängigen Ansprüchen angegeben.

Danach wird eine Verkleidungselement-Anordnung bereitgestellt, mit

- mindestens einem Verkleidungselement zum Verkleiden einer Fläche;
- mindestens einem Sender zum Erzeugen von akustischen Oberflächenwellen in dem Verkleidungselement;
- mindestens einem Empfänger zum Empfangen der erzeugten akustischen Oberflächenwelle, wobei anhand eines bei Empfang der akustischen Oberflächenwelle erzeugten Signals des Empfängers festgestellt werden kann ob eine Berührung des Verkleidungselements vorliegt; und
- Auswertemitteln, die ausgebildet sind, in Abhängigkeit von der Amplitude eines Signals des Empfängers zu ermitteln, ob eine Berührung des Verkleidungselementes vorliegt,
- wobei das Verkleidungselement eine als Sichtseite ausgebildete Vorderseite sowie eine Rückseite, über die das Verkleidungselement mit der Fläche verbunden werden kann, aufweist, und wobei der Sender und der Empfänger an der Rückseite des Verkleidungselementes angeordnet sind.

Der Sender ist insbesondere ausgebildet, Oberflächenwellen in Form von Lamb-Wellen anzuregen, wobei die Wellenlänge der angeregten akustischen Oberflächenwellen größer als die Dicke des Verkleidungselementes ist. Denkbar ist auch, dass Oberflächenwellen eines anderen Typs angeregt werden, z.B. Rayleigh-Wellen, für deren Erzeugung die Wellenlänge der angeregten Wellen kleiner sein muss als die Dicke des Verkleidungselementes, oder Lamb-Rayleigh-Wellen.

Die in dem Verkleidungselement angeregten Oberflächenwellen können mit einer die Oberfläche des Verkleidungselementes zumindest teilweise bedeckenden Flüssigkeit wechselwirken, wobei zumindest ein Teil der Energie der akustischen Oberflächenwelle in die Flüssigkeit auskoppelt, falls die Schallgeschwindigkeit der Flüssigkeit kleiner ist als die Schallgeschwindigkeit (Ausbreitungsgeschwindigkeit) der Oberflächenwelle. Der Winkel für diese Auskopplung ist charakteristisch und durch das Verhältnis dieser Geschwindigkeiten bestimmt ("akustisches Brechungsgesetz"). Dieser charakteristische Winkel $\Theta$ (der sogenannte Rayleigh-Winkel), gemessen in Bezug auf eine vertikale Referenzlinie zu der Oberfläche des Verkleidungselementes, bestimmt sich durch:

$$\Theta = \arcsin(c_M/c_S),$$

wobei $c_M$ die Schallgeschwindigkeit der Volumenwelle innerhalb der Flüssigkeit ist und $c_S$ die Schallgeschwindigkeit der akustischen Oberflächenwelle in dem Verkleidungselement.

Sobald die oben genannten Bedingungen erfüllt sind, wird zumindest ein Teil der Energie der akustischen Oberflächenwellen, die durch einen Sender, wie beispielsweise einen Interdigitalwandler erzeugt werden, in Volumenschallwellen innerhalb der Flüssigkeit umgewandelt (Modenkonversion). Die Volumenschallwellen koppeln somit unter dem Rayleigh-Winkel in die Flüssigkeit aus und reduzieren dadurch die Energie der akustischen Oberflächenwelle.

Mit Hilfe des Modenkonversionseffekts von akustischen Oberflächenwellen können auf beliebig festen Oberflächen (hier Verkleidungselemente) die Anwesenheit von bedeckenden Schichten, insbesondere Flüssigkeitsschichten und die Berührung durch menschliche Körperteile oder Gegenstände nachgewiesen werden. Die durch den Sender (der beispielsweise wie erwähnt durch einen Interdigitalwandler realisiert sein kann) erzeugte akustische Oberflächenwelle breitet sich innerhalb des Verkleidungselements aus und wird von einem Empfänger aufgenommen, der entsprechend der Energie der eingehenden akustischen Oberflächenwelle ein elektrisches Signal erzeugt.

Bei der Anwesenheit von Oberflächenbedeckungen, wie beispielsweise Flüssigkeitsschichten, oder der Berührung durch menschliche Körperteile (wie beispielsweise eines Fingers) erfolgt eine Energiereduzierung der akustischen Oberflächenwelle aufgrund des Modenkonversionseffektes. Dabei koppelt ein Teil der akustischen Oberflächenwelle unter dem Rayleigh-Winkel Θ in die Oberflächenbedeckungen (beispielsweise eine Flüssigkeitsschicht) bzw. in ein menschliches Körperteil aus. Die Auskopplung einer Volumenwelle führt zu einer Verringerung der Energie der akustischen Oberflächenwelle. Folglich wird von dem Empfänger eine energetisch herabgesetzte akustische Oberflächenwelle - im Vergleich zur ursprünglich angeregten akustischen Oberflächenwelle - empfangen.

Je nach Art der Berührung bzw. nach Art (und/oder Grad) der Oberflächenbedeckung erreicht folglich eine entsprechend der Art der Berührung energetisch herabgesetzte akustische Oberflächenwelle den Empfänger. Die erfindungsgemäße Verkleidungselementanordnung eignet sich daher beispielsweise zur Detektion einer Flüssigkeit auf dem Verkleidungselement oder einer sonstigen Berührung des Verkleidungselementes.

In einer Ausgestaltung der Erfindung ist die Verkleidungselementanordnung entsprechend so ausgebildet, dass anhand des Empfängersignals bestimmbar ist, ob eine Berührung des Verkleidungselements (z.B. durch ein menschliches Körperteil oder durch einen Gegenstand) oder eine Flüssigkeitsbedeckung, insbesondere Wasser oder feuchter Schmutz, vorliegt.

Das Verkleidungselement kann über die Rückseite mit der Fläche, insbesondere in Form einer Wand, eines Bodens oder einer Decke, verbunden, insbesondere verklebt werden.

Ein derartiges Verbinden kann beispielsweise mechanisch erfolgen, insbesondere mittels Schrauben, Verklemmen, Einrasten oder Einhaken in entsprechende Aufnahmevorrichtungen oder mittels einer anderen kraft- und/oder formschlüssigen Verbindung. Weiterhin kann ein derartiges Verbinden auch beispielsweise mittels Stoffschluss erfolgen, z.B. durch Verkleben, Fugen oder Eingipsen erfolgen.

Das Verkleidungselement hat insbesondere eine flächige (plattenartige) Form, d.h. es erstreckt sich entlang einer Ebene ("Haupterstreckungsebene"), wobei seine Ausdehnung parallel zur Haupterstreckungsebene deutlich größer ist (z.B. mindestens dreimal größer) als senkrecht zur Haupterstreckungsebene. In Draufsicht ist das Verkleidungselement z.B. rechteckig, wobei die Erfindung natürlich nicht auf diese Geometrie beschränkt ist.

Dabei kann vorgesehen sein, dass es sich bei dem Verkleidungselement um eine Fliese, insbesondere um eine keramische Fliese, handelt, die z.B. auf einem Boden oder einer Wand montiert (z.B. aufgeklebt) werden kann.

In einer weiteren Ausführungsform der Erfindung weist die Verkleidungselementanordnung eine Mehrzahl von Verkleidungselementen auf, die jeweils mindestens einen Sender und mindestens einen Empfänger aufweisen.

Beispielsweise sind die Auswertemittel in Form eines programmierten elektronischen Bausteins ausgebildet, der z.B. an dem Verkleidungselement festgelegt ist.

In einer weiteren Ausführungsform weist die Verkleidungselementanordnung eine Mehrzahl von Verkleidungselementen auf und die Auswertemittel sind ausgebildet, zu bestimmen, bei welchen der Verkleidungselemente eine Berührung vorliegt, und in Abhängigkeit von dieser Bestimmung ein Signal, insbesondere ein Alarmsignal zu erzeugen.

Alternativ können die Auswertemittel auch ausgebildet sein, zu bestimmen, welcher Bereich der einzelnen Verkleidungselemente (bei einer Mehrzahl von Verkleidungselementen) von einer Berührung betroffen ist und in Abhängigkeit von dieser Bestimmung ein Signal zu erzeugen, welches geeignet ist, die Form der Berührung festzustellen. Beispielsweise könnte dadurch festgestellt werden, ob eine Person auf den Verkleidungselementen liegt (etwa ohnmächtig geworden ist), d.h. ob eine Notfallsituation vorliegt. In Abhängigkeit von der Auswertung des Empfängersignals (bzw. der mehreren Empfängersignale der einzelnen an den Verkleidungselementen angeordneten Empfänger) wird dann ein Alarmsignal ausgelöst.

In einer weiteren Ausgestaltungsform sind die Sender und der Empfänger als Interdigitalwandler ausgebildet.

Die Erfindung betrifft auch ein Verfahren zur Herstellung einer berührungsempfindlichen Verkleidung einer Fläche, mit den Schritten:

- Bereitstellen mindestens eines Verkleidungselementes, insbesondere in Form einer keramischen oder sonstigen Fliese;
- Anordnen mindestens eines Senders zum Erzeugen von akustischen Oberflächenwellen in dem Verkleidungselement an dem Verkleidungselement ; und
- Anordnen mindestens eines Empfängers zum Empfangen der erzeugten akustischen Oberflächenwellen an dem Verkleidungselement; und
- Bereitstellen von Auswertemitteln, die ausgebildet sind, in Abhängigkeit von der Amplitude eines Signals des Empfängers zu ermitteln, ob eine Berührung des Verkleidungselementes vorliegt
- wobei das Verkleidungselement eine als Sichtseite ausgebildete Vorderseite sowie eine Rückseite, über die das Verkleidungselement mit der Fläche verbunden werden kann, aufweist, und wobei der Sender und der Empfänger an der Rückseite des Verkleidungselementes angeordnet sind.

Wie erwähnt, können die Verkleidungselemente in Form handelsüblicher Fliesen ausgebildet sein, die mit Hilfe der erfindungsgemäßen Erzeugung von akustischen Oberflächenwellen gegenüber einer Bedeckung von beispielsweise Flüssigkeiten oder einer Berührung durch menschliche Körperteile sensitiv gemacht werden. Hierzu werden z.B. auf ihre Rückseite in geeigneter Weise piezoelektrische Interdigitalwandler oder sonstige Sender und/oder Empfänger derart angeordnet, dass eine Übertragungsstrecke für Oberflächenwellen (insbesondere Lamb-Wellen) entsteht, die sich auf (bzw. in) der Fliese ausbreiten und damit auch die die Vorderseite (Sichtseite) sensitiv wird.

Mit derartigen Fliesen können insbesondere Wände und Bodenflächen berührungssensitiv gemacht werden, ohne zusätzliche Schalt- oder Sensorelemente anbringen zu müssen. Der Empfänger oder die erwähnten Auswertemittel können über eine rückseitige, in der Wand verlegte Verkabelung, gegebenenfalls auch kabellos über eine Funkverbindung, mit einem Endgerät (z.B. einem Computer oder einem Display) verbunden sein.

Durch geeignete Anordnung von mehreren berührungssensitiven Verkleidungselementen und z.B. von mehreren Übertragungsstrecken auf den jeweiligen Verkleidungselementen können unterschiedliche Berührungs- und Bedeckungsmuster identifiziert werden, wie oben bereits angedeutet. Damit können zum Beispiel gleichmäßige Flüssigkeitsbelegungen (zum Beispiel verursacht durch Überlaufen einer Badewanne) von ungleichmäßig verteilten Berührungssituationen mit menschlichen Körperteilen (zum Beispiel Stürze) unterschieden werden. Es können auch Not-Abschalteschalter oder Alarmschalter durch geeignete Anordnungskonfigurationen der Verkleidungselemente realisiert und voneinander unterschieden werden.

Die erfindungsgemäßen Verkleidungselemente können an bzw. in Bauwerken (z.B. Gebäuden wie Wohn- oder Bürohäusern) oder insbesondere in Räumen von Gebäuden Anwendung finden.

Insbesondere können die erfindungsgemäßen Verkleidungselemente in Sanitärräumen eingesetzt werden. In Sanitärräumen befinden sich viele Schalter, wie beispielsweise für Licht, Wasser oder die WC-Spülung, die meist elektro-mechanisch oder mechanisch betätigt werden. An den meisten dieser elektro-mechanischen oder mechanischen Bauteile lagern sich baubedingt Verunreinigungen oder Schmutz ab, die schwer zu entfernen sind.

Auch sind häufig elektro-mechanische Bauteile nicht ausreichend gegen Wassereintritt geschützt, so dass es zu Kurzschlüssen kommen kann. Ersetzt man diese elektro-mechanischen oder mechanischen Bauteile durch ein berührungssensitives Verkleidungselement (wie beispielsweise eine Fliese), wird eine saubere Integration der Schaltfunktion in die Umgebung geschaffen, die darüber hinaus deutlich einfacher zu reinigen ist, da sie keine schwer zugänglichen, bauteilbedingten Bereiche aufweist, in denen sich häufig Verunreinigungen ablagern.

Derartige berührungssensitive Verkleidungselemente verfügen somit über einen deutlichen hygienischen Vorteil gegenüber den bekannten elektro-mechanischen oder mechanischen Bauteilen. Die erfindungsgemäßen Verkleidungselemente können absolut wasserdicht ausgebildet sein und verfügen dadurch über einen deutlich höheren Sicherheitsvorteil hinsichtlich herkömmlicher Schalter in Bezug auf Kurzschlüsse durch Wassereintritt.

Auch kann die Verwendung der erfindungsgemäßen Verkleidungselemente in beispielsweise öffentlichen Toiletten die Hygiene erhöhen bzw. die Geruchsbelästigung vermindern, wenn beispielsweise beim Verlassen des WCs automatisch ein Spülvorgang eingeleitet wird, wenn die Toilettenbrille selbst berührungssensitiv ausgebildet ist.

Auch die Sicherheit von Personen in den Sanitärräumen kann durch beispielsweise berührungssensitive Fliesen erhöht werden. Wird der gesamte Boden des Sanitärraums mit sensitiven Fliesen ausgestattet, erhält man eine Vielzahl von Informationen über das Raumgeschehen. So kann beispielsweise der Sturz einer Person, insbesondere einer älteren oder pflegebedürftigen Person, mit anschließender Liegephase erkannt werden und daraufhin gegebenenfalls ein Notruf abgesetzt werden. Selbstverständlich ist eine derartige Ausgestaltung nicht nur auf Sanitärräume beschränkt.

Da das vom Empfänger gemessene Messsignal der akustischen Oberflächenwelle nicht nur von der sich auf dem Verkleidungselement befindlichen Oberflächenschicht (wie beispielsweise eine Wasserschicht) beeinflusst wird, sondern auch von dessen Höhe oder Bedeckungsfläche, kann beispielsweise eine Überschwemmung frühzeitig automatisiert erkannt werden und können durch beispielsweise ein automatisches Schließen des Haupthahns größere Schäden vermieden werden.

Durch die aktuellen Entwicklungen neuer Wohnkonzepte für ältere Menschen, ist es älteren Menschen häufig möglich, selbständig in einem eigenen Wohnumfeld zu agieren. Meist werden zur Entlastung nur Zusatzleistungen wie beispielsweise Reinigungskräfte oder häusliche Krankenpflegedienste benötigt.

Durch die erfindungsgemäße Verkleidungselementanordnung ist es beispielsweise möglich, die Sicherheit für ältere Menschen zu erhöhen. Wie bereits beschrieben, ist es möglich, eine längere Liegeposition eines Menschen durch beispielsweise einen Sturz zu erkennen und folgerichtig einen Alarm auszulösen.

Auch ist es möglich, dass eine längere Abwesenheit von irgendwelchen Kontakten auf den Verkleidungselementen einen Notruf erzeugt. Dies kann beispielsweise mit einer Zeitschaltung gekoppelt sein, so dass zu bestimmten Zeiten, bei denen für gewöhnlich kein Kontakt mit den Verkleidungselementen vorliegt (wie beispielsweise nachts während des Schlafes) kein Fehlalarm ausgelöst wird. Dadurch kann gewährleistet werden, dass ein Notruf eingeleitet wird, wenn älteren und kranken Menschen beispielsweise etwas in ihrem Bett oder auf einem Sofa widerfährt, so dass sie im Wesentlichen bewegungsunfähig sind. Die Erfindung umfasst entsprechend ausgebildete Auswertemittel, wie oben bereits angedeutet. Die Auswertemittel können an dem Verkleidungselement vorgesehen sein oder auch zumindest teilweise separat (beabstandet) zu dem Verkleidungselement positioniert (und per Kabel oder Funk mit dem Verkleidungselement verbunden) sein.

Weiterhin können bei berührungssensitiven Verkleidungselementen auch Langzeitbetrachtungen des Signals vorgenommen werden, wobei sich beispielsweise Biofilmablagerungen (Schmutz) signifikant auf den Trend der Messdaten auswirken. So lässt sich beispielsweise ein zulässiger Grad an Verschmutzung erkennen, so dass die Reinigungszyklen an den realen Bedarf angepasst werden und somit zu einer Kosteneinsparung führen.

Insbesondere ist darauf hinzuweisen, dass neben keramischen Werkstoffen vor allem Glas, Metall und Plastikoberflächen einsetzbar sind, so dass sich ein breiter Anwendungsbereich im Bereich der weißen Ware (Haushaltsgeräte) und im Kraftfahrzeug-Bereich erschließt. Mit den erfindungsgemäßen Verkleidungselementen können Schaltfunktionen auf den unterschiedlichsten Oberflächen und Objekten realisiert werden, ohne dass dabei die Oberfläche des Objekts verändert werden muss bzw. so dass anstatt von verschiedenen Bauelementen auf der Oberfläche nun eine glatte Oberfläche möglich ist.

Die Erfindung wird im Folgenden anhand von Ausführungsbeispielen unter Bezugnahme auf die Figuren näher erläutert. Es zeigen:

Fig. 1      eine schematische Darstellung eines Interdigitalwandlers;

Fig. 2      eine Darstellung von Oberflächenwellen auf einer Glasoberfläche;

Fig. 3      ein erstes Ausführungsbeispiel eines Verkleidungselements;

Fig. 4      eine Messung einer gesendeten und empfangenen akustischen Oberflächenwelle bei einer Berührung und bei keiner Berührung;

Fig. 5      eine schematische Draufsicht einer zweiten Ausführungsform;

Fig. 6      eine schematische Unteransicht einer zweiten Ausführungsform;

Fig. 7A-B      eine schematische Ansicht einer dritten Ausführungsform bei unterschiedlichen Höhen einer Oberflächenbedeckung.

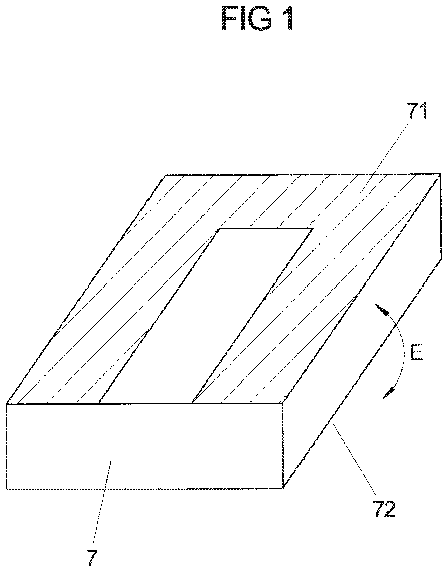

Fig. 1 zeigt eine schematische Ansicht eines Interdigitalwandlers 7, der als Sender und/oder Empfänger an einem Verkleidungselement angeordnet werden könnte. Ein Interdigitalwandler besteht aus einem piezoelektrischen Substrat 7 an dessen Oberseite und Unterseite eine Elektrode 71, 72 angebracht ist. Im Sendefall regt eine zwischen den Elektroden angelegte elektrische Wechselspannung auf Grund der piezoelektrischen Eigenschaften des Substrats eine Vorschwingung E und damit in einem kraftschlüssig verbundenen Verkleidungselement (nicht dargestellt) eine akustische Oberflächenwelle an. Im Empfangsfall erzeugt eine einlaufende akustische Oberflächenwelle ebenfalls aufgrund des Piezoeffekts eine elektrische Wechselspannung.

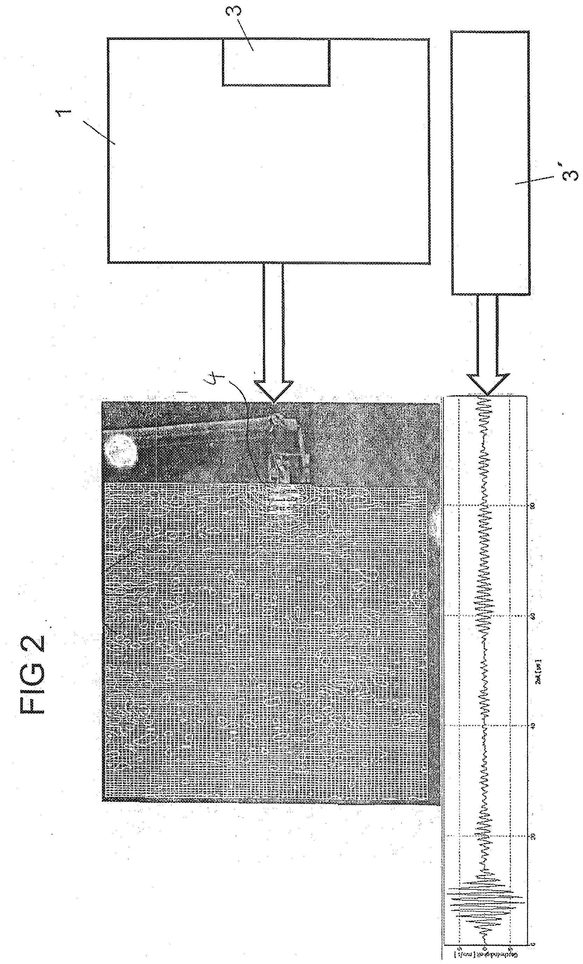

Fig. 2 zeigt eine Darstellung der Einkopplung von Oberflächenwellen 4 in ein Verkleidungselement 1 - in diesem Fall eine Glasplatte - welche durch einen Sender 3 - hier ein Interdigitalwandler - angeregt wurden. Die Signalentwicklung 3' des Interdigitalwandlers 3 ist auf einem Geschwindigkeitszeitdiagramm dargestellt. Vorliegend erfolgte die Messung der Auslenkung der Glasplatte per Laservibrometer, das die Geschwindigkeit der ausgelenkten Segmente der Glasplatte erfasst (wobei das unterhalb der Darstellung der Glasplatte abgebildete Geschwindigkeitszeitdiagramm eine Momentaufnahme der Segmentgeschwindigkeiten entlang einer Linie der Glasplatte zeigt).

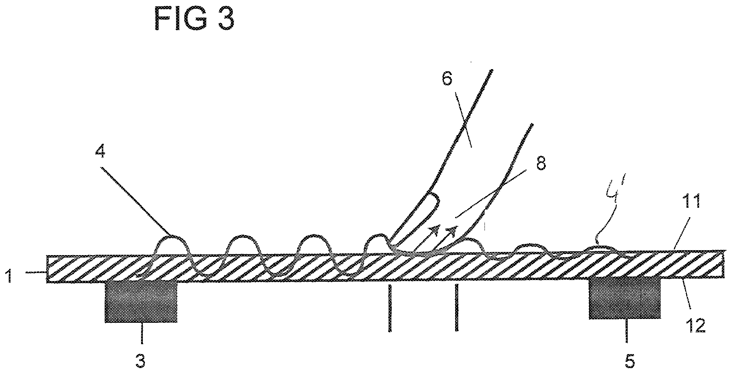

Fig. 3 zeigt ein erstes Ausführungsbeispiel eines erfindungsgemäßen Verkleidungselements 1, das eine plattenartige Gestalt besitzt. Das Verkleidungselement 1 weist eine erste Seite 11 (Sichtseite) und eine der ersten Seite 11 gegenüberliegende zweite Seite 12 (Unterseite) auf. An der zweiten Seite 12 ist ein Sender 3 in Form eines Interdigitalwandlers angeordnet. Weiterhin ist ein Empfänger 5 ebenfalls in Form eines Interdigitalwandlers in einem bestimmten Abstand zu dem Sender 3 an der Unterseite 12 des Verkleidungselements 1 angeordnet. Denkbar ist auch, dass Sender 3 und Empfänger 5 jeweils auch als Empfänger bzw. Sender betrieben werden können.

Durch die in einem gewissen Abstand zueinander angeordneten Sender 3 und Empfänger 5 entsteht eine Übertragungsstrecke für akustische Oberflächenwellen 4 - wie beispielsweise Lamb-Wellen - die sich auf dem Verkleidungselement 1 ausbreiten. Durch eine Berührung des Verkleidungselements 1 mittels eines menschlichen Körperteils - hier dargestellt durch einen Finger 6 - findet eine Modenkonversion statt.

Dabei wird ein Teil der sich vom Sender 3 hin zum Empfänger 5 ausbreitenden akustischen Oberflächenwelle 4 in den Finger 6 in einem charakteristischen Winkel (Rayleigh-Winkel) als Volumenwelle 8 ausgekoppelt. Durch die Auskopplung eines Teils der akustischen Oberflächenwelle 4 als Volumenwelle 8 in den Finger 6 wird die Energie der akustischen Oberflächenwelle 4 herabgesetzt und eine gedämpfte akustische Oberflächenwelle 4' erreicht den Empfänger 5.

Beispielsweise kann dann durch ein hier nicht dargestelltes Auswertemittel aufgrund des vom Empfänger 5 erzeugten Signals, welches durch die Energie der empfangenen akustischen Oberflächenwelle 4' bestimmt wird, festgestellt werden, ob eine Berührung des Verkleidungselementes 1 vorliegt oder nicht. In Abhängigkeit von dieser Bestimmung kann das Auswertemittel ein weiteres Signal erzeugen, um beispielsweise einen elektrischen Schaltkreis zu schließen und somit z. B. ein Licht anzuschalten oder um einen Alarm auszulösen. Neben der Amplitude der am Empfänger 5 einlaufenden Oberflächenwellen 4' kann auch die Laufzeit der Wellen (insbesondere wenn diese in Form von Wellenpulsen angeregt werden) herangezogen werden, um eine Bedeckung des Verkleidungselementes 1 zu bestimmen. Denkbar ist auch, dass nicht nur in dem Verkleidungselement 1 laufende Oberflächenwellen 4, 4' sondern auch Volumenschallwellen in einem auf dem Verkleidungselement vorhandenen Medium (z.B. eine Flüssigkeit) mit dem Empfänger 5 detektiert (nachdem sie in Oberflächenschallwellen rekonvertiert wurden) und in die Signalauswertung einbezogen werden.

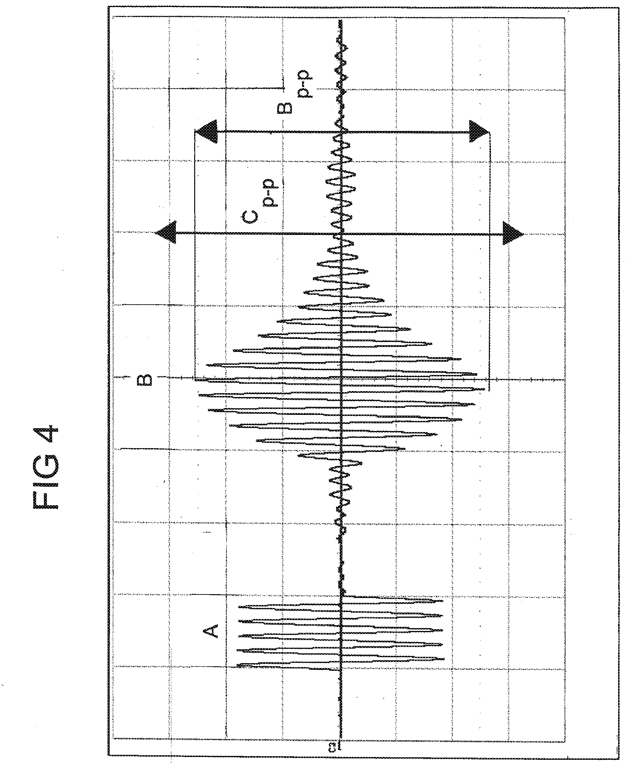

Fig. 4 zeigt eine Messung eines gesendeten Transmitter-Signals A (mit dem Oberflächenschallwellen in dem Verkleidungselement angeregt werden) im Vergleich mit einem Receiversignal B bei Empfang der vom Sender angeregten Oberflächenschallwellen, wobei eine Berührung des Verkleidungselementes vorliegt.. Der Spitze-zu-Spitze-Wert $B_{p-p}$ des Empfängersignals B bei Berührung des flächigen Elementes ist kleiner als der Spitze-zu-Spitze-Wert $C_{p-p}$ ohne Berührung, so dass z.B. in Abhängigkeit von dem Spitze-zu-Spitze-Wert (bzw. der Amplitude) des Empfängersignals das Vorliegen einer Berührung erkannt werden kann. Denkbar ist z.B., dass eine Berührung signalisiert wird, wenn sich der gemessene Spitze-zu-Spitze-Wert um eine vorgebbare Differenz von einem Spitze-zu-Spitze-Ausgangswert unterscheidet.

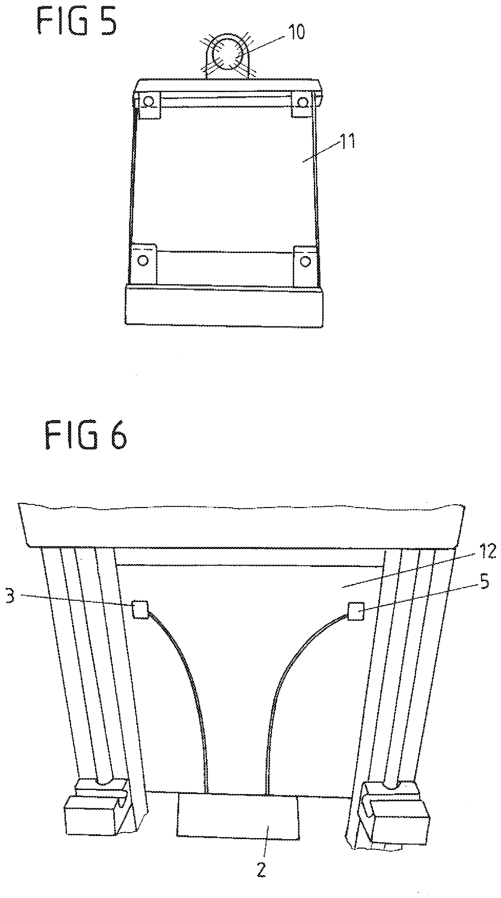

Fig. 5 zeigt eine schematische Ansicht einer zweiten Ausführungsform eines Verkleidungselements 1 in einer Draufsicht. Eine Unteransicht der zweiten Ausführungsform ist in Fig. 6 dargestellt. Wie man aus den Figuren erkennen kann, wird durch ein Berühren der ersten Seite 11 - der Sichtseite - beispielsweise ein Leuchte 10 aus- bzw. wie hier dargestellt angeschaltet. Die Leuchte 10 und das Verkleidungselement 1 bilden eine Einheit.

Wie in der Unteransicht der Fig. 6 erkennbar ist, erfolgt eine Übertragung der akustischen Oberflächenwellen (hier nicht dargestellt) von dem an der zweiten Seite 12 (Unterseite) des Verkleidungselements 1 angeordneten Sender 3 hin zu dem Empfänger 5. Folglich breiten sich die akustischen Oberflächenwellen 4 (z.B. Lamb-Wellen) auf der Fliese 1 aus. Dadurch wird auch die Sichtseite 11 des Verkleidungselements 1 berührungssensitiv, da durch eine Berührung beispielsweise mittels eines menschlichen Körperteils ein Teil der akustischen Oberflächenwelle 4 ausgekoppelt wird und die beim Empfänger 5 ankommende akustische Oberflächenwelle 4' folglich mit geringerer Energie/Amplitude ankommt. Dieses Prinzip wurde bereits ausführlich anhand der Fig. 3 erläutert.

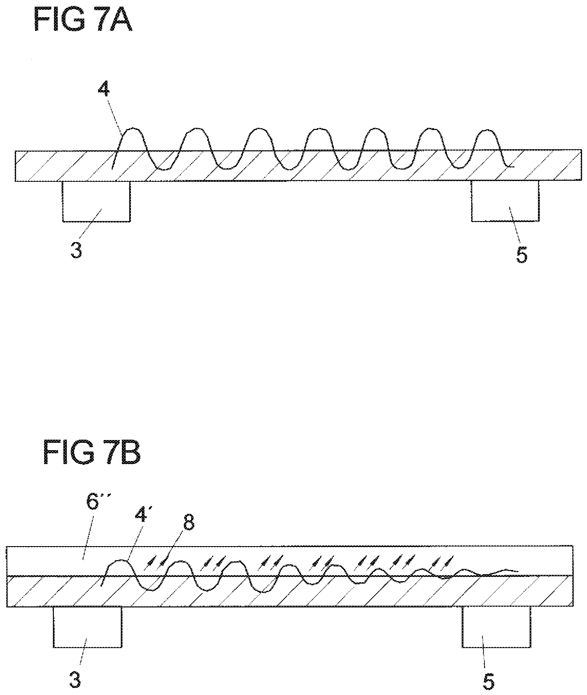

Fig. 7A und 7B betreffen eine dritte Ausführungsform der Erfindung. Fig. 7A zeigt schematisch die Ausbreitung einer akustischen Oberflächenwelle 4 von einem Sender 3 zu einem Empfänger 5 innerhalb des Verkleidungselements 1.

Auf dem Verkleidungselement 1 der Figur 7A findet keine Berührung statt. Die vom Sender 3 erzeugte akustische Oberflächenwelle 4 kommt somit im Wesentlichen im gleichen energetischen Zustand beim Empfänger 5 an. Die Fig. 7B zeigt das Verkleidungselement 1 bei Berührung, wobei die Berührung dadurch erfolgt, dass sich auf dem Verkleidungselement 1 eine für eine Auskopplung von Volumenschallwellen geeignete Oberflächenschicht 6" befindet, beispielsweise eine Flüssigkeitsschicht. Entsprechend dem oben bereits beschriebenen Prinzip der Modenkonversion wird ein Teil der akustischen Oberflächenwelle 4' als Volumenschallwellen 8 in die Oberflächenschicht 6" ausgekoppelt, so dass die akustischen Oberflächenwellen 4' innerhalb der Übertragungsstrecke zwischen dem Sender 3 und Empfänger 5 an Energie verlieren. Dieses Prinzip wurde bereits ausführlich bei dem Ausführungsbeispiel der Fig. 3 beschrieben.

Da die Auskopplung der akustischen Oberflächenwelle 4 in eine weitere Oberflächenschicht 6", wie beispielsweise eine Flüssigkeitsschicht, auch von der Höhe und von der Bedeckungsfläche beeinflusst wird, wird entsprechend dem bereits erläuterten Prinzip der Modenkonversion das empfangene Messsignal beeinflusst. Beispielsweise kann mit einem hier nicht dargestellten Auswertemittel die Höhe der Flüssigkeitsschicht 6" bestimmt werden und bei Überschreitung eines gewissen Grenzwertes ein Alarmsignal ausgelöst werden, wie beispielsweise beim Überlaufen einer Badewanne.

Bezugszeichenliste

| | |
|---|---|
| 1 | Verkleidungselement |
| 2 | Auswertemittel |
| 3 | Sender |
| 4, 4', 4" | Oberflächenwellen |
| 5 | Empfänger |
| 6 | menschliches Körperteil |
| 6' | Gegenstand |
| 6" | Oberflächenschicht |
| 10 | Leuchte |
| 11 | Erste Seite (Sichtseite) |
| 12 | Zweite Seite (Unterseite) |

**Patentansprüche**

1. Verkleidungselementanordnung, mit

- mindestens einem Verkleidungselement (1) zum Verkleiden einer Fläche;
- mindestens einem Sender (3) zum Erzeugen von akustischen Oberflächenwellen (4) in dem Verkleidungselement (1);
- mindestens einem Empfänger (5) zum Empfangen der erzeugten akustischen Oberflächenwellen (4), wobei anhand eines bei Empfang der akustischen Oberflächenwellen (4) erzeugten Signals des Empfängers (5) festgestellt werden kann, ob eine Berührung des Verkleidungselementes (1) vorliegt, wobei das Verkleidungselement (1) eine als Sichtseite ausgebildete Vorderseite sowie eine Rückseite, über die das Verkleidungselement (1) mit der Fläche verbunden werden kann, aufweist, und wobei der Sender (3) und der Empfänger (5) an der Rückseite des Verkleidungselementes (1) angeordnet sind, **gekennzeichnet durch** Auswertemittel (2), die ausgebildet sind, anhand der Amplitude eines bei Empfang der akustischen Oberflächenwellen (4) erzeugten Signals des Empfängers (5) zu bestimmen, ob eine Berührung des Verkleidungselementes (1) vorliegt.

2. Verkleidungselementanordnung nach Anspruch 1, **dadurch gekennzeichnet, dass** sie ausgebildet ist, anhand des Empfängersignals eine Berührung des Verkleidungselements (1) durch ein menschliches Körperteil (6) oder durch einen sonstigen Gegenstand (6') zu erkennen.

3. Verkleidungselementanordnung nach Anspruch 1 oder 2, **dadurch gekennzeichnet, dass** die Berührung des Verkleidungselements (1) mittels einer Oberflächenschicht (6''), insbesondere Wasser oder feuchtem Schmutz, erfolgt.

4. Verkleidungselementanordnung nach einem der vorhergehenden Ansprüche, **dadurch gekennzeichnet, dass** das Verkleidungselement (1) über die Rückseite mit der Fläche verklebt werden kann.

5. Verkleidungselementanordnung nach einem der vorhergehenden Ansprüche, **dadurch gekennzeichnet, dass** es sich bei dem Verkleidungselement (1) um eine Fliese, insbesondere um eine keramische Fliese, handelt.

6. Verkleidungselementanordnung nach einem der vorhergehenden Ansprüche, **gekennzeichnet durch** eine Mehrzahl von Verkleidungselementen (1), die jeweils mindestens einen Sender (3) und mindestens einen Empfänger (5) aufweisen.

7. Verkleidungselementanordnung nach Anspruch 6, **dadurch gekennzeichnet, dass** eine Mehrzahl von Verkleidungselementen (1) vorhanden ist und die Auswertemittel (2) ausgebildet sind, zu bestimmen, bei welchen der Verkleidungselementen (1) eine Berührung vorliegt, und in Abhängigkeit von dieser Bestimmung ein Signal, insbesondere ein Alarmsignal, zu erzeugen.

8. Bauwerk mit einer Verkleidungselementanordnung nach einem der vorhergehenden Ansprüche.

9. Raum mit einer Verkleidungselementanordnung nach einem der vorhergehenden Ansprüche.

10. Verfahren zum Herstellen einer berührungsempfindlichen Verkleidung einer Fläche, mit den Schritten:

- Bereitstellen mindestens eines Verkleidungselementes (1), insbesondere in Form einer keramischen oder sonstigen Fliese;
- Anordnen mindestens eines Senders (3) zum Erzeugen von akustischen Oberflächenwellen (4) in dem Verkleidungselement (1) an dem Verkleidungselement (1); und
- Anordnen mindestens eines Empfängers (5) zum Empfangen der erzeugten akustischen Oberflächenwellen (4) an dem Verkleidungselement (1), wobei das Verkleidungselement (1) eine als Sichtseite ausgebildete Vorderseite sowie eine Rückseite, über die das Verkleidungselement (1) mit der Fläche verbunden werden kann, aufweist, und wobei der Sender (3) und der Empfänger (5) an der Rückseite des Verkleidungselementes (1) angeordnet sind, **gekennzeichnet durch** Bereitstellen von Auswertemitteln (2), die ausgebildet sind, anhand der Amplitude eines bei Empfang der akustischen Oberflächenwellen (4) erzeugten Signals des Empfängers (5) zu bestimmen, ob eine Berührung des Verkleidungselementes (1) vorliegt.

## Claims

1. Cladding element assembly having

- at least one cladding element (1) for cladding a surface;
- at least one transmitter (3) for generating acoustic surface waves (4) in the cladding element (1);
- at least one receiver (5) for receiving the generated acoustic surface waves (4), wherein on the basis of a signal of the receiver (5), generated when the acoustic surface waves (4) are received, it can be detected whether there is contact with the cladding element (1), wherein the cladding element (1) has a front side which is embodied as a visible side, and a rear side via which the cladding element (1) can be connected to the surface, and wherein the transmitter (3) and the receiver (5) are arranged on the rear side of the cladding element (1), **characterized by** evaluation means (2) which are configured to determine whether there is contact with the cladding element (1), on the basis of the amplitude of a signal of the receiver (5), which is generated when the acoustic surface waves (4) are received.

2. Cladding element assembly according to Claim 1, **characterized in that** said assembly is configured to detect, on the basis of the receiver signal, contact with the cladding element (1) by a human body part (6) or by some other object (6').

3. Cladding element assembly according to Claim 1 or 2, **characterized in that** the contact with the cladding element (1) takes place by means of a surface layer (6"), in particular water or moist dirt.

4. Cladding element assembly according to one of the preceding claims, **characterized in that** the cladding element (1) can be bonded to the surface via the rear side.

5. Cladding element assembly according to one of the preceding claims, **characterized in that** the cladding element (1) is a tile, in particular a ceramic tile.

6. Cladding element assembly according to one of the preceding claims, **characterized by** a multiplicity of cladding elements (1) which each have at least one transmitter (3) and at least one receiver (5).

7. Cladding element assembly according to Claim 6, **characterized in that** a plurality of cladding elements (1) are present, and the evaluation means (2) are designed to determine at which of the cladding elements (1) contact is occurring, and to generate a signal, in particular an alarm signal, as a function of this determination.

8. Building having a cladding element assembly according to one of the preceding claims.

9. Space having a cladding element assembly according to one of the preceding claims.

10. Method for manufacturing touch-sensitive cladding of a surface, having the steps:

- making available at least one cladding element (1), in particular in the form of a ceramic nonwoven or some other nonwoven;

- arranging on the cladding element (1) at least one transmitter (3) for generating acoustic surface waves (4) in the cladding element (1); and
- arranging at least one receiver (5) for receiving the generated acoustic surface waves (4) on the cladding element (1), wherein the cladding element (1) has a front side which is embodied as a visible side and a rear side via which the cladding element (1) can be connected to the surface, wherein the transmitter (3) and the receiver (5) are arranged on the rear side of the cladding element (1), **characterized by** the provision of evaluation means (2) which are configured to determine whether there is contact with the cladding element (1), on the basis of the amplitude of a signal of the receiver (5), generated when the acoustic surface waves (4) are received.

**Revendications**

1. Ensemble d'éléments de revêtement, comprenant

- au moins un élément de revêtement (1) destiné au revêtement d'une surface ;
- au moins un émetteur (3) destiné à générer des ondes de surface acoustiques (4) dans l'élément de revêtement (1) ;
- au moins un récepteur (5) destiné à recevoir les ondes de surface acoustiques générées (4), un signal du récepteur (5), généré lors de la réception des ondes de surface acoustiques (4), permettant de déterminer la présence d'un contact de l'élément de revêtement (1), l'élément de revêtement (1) comportant un côté avant conçu comme un côté visible et un côté arrière permettant de relier l'élément de revêtement (1) à la surface, et l'émetteur (3) et le récepteur (5) étant disposés sur le côté arrière de l'élément de revêtement (1), **caractérisé par** des moyens d'évaluation (2) qui sont conçus pour déterminer, sur la base de l'amplitude d'un signal du récepteur (5), généré lors de la réception des ondes de surface acoustiques (4), la présence d'un contact de l'élément de revêtement (1).

2. Ensemble d'éléments de revêtement selon la revendication 1, **caractérisé en ce que** celui-ci est conçu pour détecter un contact de l'élément de revêtement (1) par une partie de corps humain (6) ou par un autre objet (6') sur la base du signal de récepteur.

3. Ensemble d'éléments de revêtement selon la revendication 1 ou 2, **caractérisé en ce que** le contact de l'élément de revêtement (1) est effectué au moyen d'une couche de surface (6"), en particulier de l'eau ou d'une souillure humide.

4. Ensemble d'éléments de revêtement selon l'une des revendications précédentes, **caractérisé en ce que** l'élément de revêtement (1) peut être collé à la surface par le côté arrière.

5. Ensemble d'éléments de revêtement selon l'une des revendications précédentes, **caractérisé en ce que** l'élément de revêtement (1) est un carreau, notamment un carreau de céramique.

6. Ensemble d'éléments de revêtement selon l'une des revendications précédentes, **caractérisé par** une pluralité d'éléments de revêtement (1) comportant chacun au moins un émetteur (3) et au moins un récepteur (5).

7. Ensemble d'éléments de revêtement selon la revendication 6, **caractérisé en ce qu'**une pluralité d'éléments de revêtement (1) sont présents et les moyens d'évaluation (2) sont conçus pour déterminer dans lequel des éléments de revêtement (1) il y a un contact, et pour générer un signal, notamment un signal d'alarme, en fonction de cette détermination.

8. Bâtiment pourvu d'un ensemble d'éléments de revêtement selon l'une des revendications précédentes.

9. Espace pourvu d'un ensemble d'éléments de revêtement selon l'une des revendications précédentes.

10. Procédé de fabrication d'un revêtement tactile d'une surface, le procédé comprenant les étapes suivantes :

- fournir au moins un élément de revêtement (1), se présentant notamment sous la forme d'un carreau de céramique ou autre ;
- disposer sur l'élément de revêtement (1) au moins un émetteur (3) destiné à générer des ondes de surface acoustiques (4) dans l'élément de revêtement (1) ; et
- disposer sur l'élément de revêtement (1) au moins un récepteur (5) destiné à recevoir les ondes de surface acoustiques générées (4), l'élément de revêtement (1) comportant un côté avant conçu comme un côté visible et un côté arrière permettant de relier l'élément de revêtement (1) à la surface et l'émetteur (3) et le récepteur (5) étant disposés sur le côté arrière de l'élément de revêtement (1),
**caractérisé par**
la fourniture de moyens d'évaluation (2) qui sont conçus pour déterminer la présence d'un contact de l'élément de revêtement (1) sur la base de l'amplitude d'un signal du récepteur (5), généré lors de la réception des ondes de surface acoustiques (4).

# FIG 1

71

7

72

E

FIG 2

FIG 3

## FIG 4

FIG 5

FIG 6

EP 2 432 126 B1

## FIG 7A

4

3

5

## FIG 7B

6″   4′   8

3

5

15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6741237 B1

- FR 2927574 A1